# EUROPEAN PATENT APPLICATION

(11) **EP 3 633 714 A1**
(43) Date of publication of application: **08.04.2020**
(21) Application number: 18809648.1
(22) Date of filing: 24.05.2018
(51) Int. Cl.: H01L 21/56

(54) **SUPPORT SUBSTRATE**

(30) Priority: 30.05.2017 JP 2017106702
(71) Applicant: Kyocera Corporation, Kyoto-shi Kyoto 612-8501 (JP)
(72) Inventor: HIGASHI,Kouji, Kyoto-shi Kyoto 612-8501 (JP)
(74) Representative: Viering, Jentschura & Partner mbB Patent- und Rechtsanwälte
(86) International application number: PCT/JP2018/020033
(87) International publication number: WO 2018/221379

(57) **Abstract**

A support substrate according to the present disclosure is made of a ceramic, and is a plate-shaped body including a first surface and a second surface positioned opposite to the first surface. An arithmetic mean roughness Ra of the first surface obtained from a roughness curve is equal to or less than 0.5 µm, and a skewness Rsk of the first surface obtained from a roughness curve is minus.

## Description

### Field

The present disclosure relates to a support substrate.

### Background

There have been proposed a Wafer Level Package (WLP) and a Panel Level Package (PLP) as a novel semiconductor packaging format that does not use wire bonding, solder bump, or interposer. A general manufacturing method of the WLP and the PLP is as follows. First, a bonding film is pasted on a support substrate. Next, a plurality of semiconductor chips is mounted on the bonding film, and then the semiconductor chips are sealed with the use of a sealing material. Next, the semiconductor chips and the sealing material are peeled away from the bonding film. Next, rewiring and dicing subsequent thereto are performed on the semiconductor chips to manufacture a WLP.

As a method for peeling semiconductor chips and a sealing material from a bonding film, there presents a method using heat, solvent, laser, or the like, or a method for mechanically peeling. The method using heat is capable of peeling semiconductor chips and a sealing material by a simpler process compared with the methods using solvent and laser or the method for mechanically peeling, so that it is possible to reduce equipment investing cost.

For example, Patent Literature 1 describes the following method as the method using heat. First, a thermo-sensitive adhesive as a bonding film is arranged on a support body, and a plurality of semiconductor chips is arranged on the thermo-sensitive adhesive. Next, the arranged semiconductor chips are sealed by using plastic as a sealing material. Next, an adhesive property of the thermo-sensitive adhesive is eliminated by heating up to equal to or more than a predetermined temperature from the above-mentioned state so as to peel the semiconductor chips and the sealing material from the thermo-sensitive adhesive.

### Citation List

### Patent Literature

Patent Literature 1: US Patent Application Publication No. 2006-0183269

### Summary

A support substrate according to the present disclosure is made of a ceramic and is a plate-shaped body including a first surface and a second surface that is positioned opposite to the first surface. An arithmetic mean roughness Ra of the first surface obtained from a roughness curve is equal to or less than 0.5 µm, and a skewness Rsk of the first surface obtained from a roughness curve is minus.

### Brief Description of Drawings

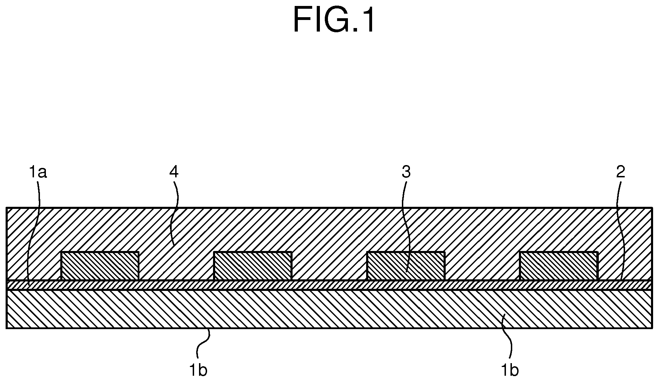

FIG. 1 is a cross sectional view schematically illustrating a state in a manufacturing process of a WLP using a support substrate according to the present disclosure.

### Description of Embodiments

In a method using heat, it is requested, for a support substrate, that a bonding strength to a bonding film is high so that the bonding film is not peeled along with semiconductor chips and a sealing material when the semiconductor chips and the sealing material are peeled away from the bonding film (hereinafter, may be referred to as "peeling process").

The support substrate according to the present disclosure has a high bonding strength to the bonding film. Hereinafter, details of the support substrate according to the present disclosure will be explained with reference to FIG. 1.

As illustrated in FIG. 1, a support substrate 1 according to the present disclosure is a plate-shaped body that includes a first surface 1a and a second surface 1b positioned opposite to the first surface 1a. In FIG. 1, a case is exemplified in which a bonding film 2 is pasted to the first surface 1a of the support substrate 1, a plurality of semiconductor chips 3 is arranged on the bonding film 2, and the semiconductor chips 3 are sealed by a sealing material 4.

The support substrate 1 according to the present disclosure is made of ceramic. Ceramic has an excellent corrosion resistance and an excellent heat resistance, and further has the rigidity higher than that of metal, glass, etc. By employing such a configuration, when the stress due to cure shrinkage of the sealing material 4 occurs in sealing the semiconductor chips 3 with the use of the sealing material 4, the support substrate 1 according to the present disclosure is not readily bent compared with a support substrate made of metal or glass. Thus, positional misalignment of the semiconductor chips 3 due to a bend of the support substrate 1 is not readily generated, thereby leading to a high yield.

For example, an aluminum-oxide-based ceramic, a silicon-nitride-based ceramic, an aluminum-nitride-based ceramic, a silicon-carbide-based ceramic, a cordierite-based ceramic, etc. are exemplified as the ceramic. Particularly, when the support substrate 1 according to the present disclosure is made of an aluminum-oxide-based ceramic among ceramics, processing is easy, so that it is possible to reduce the manufacturing cost. When the support substrate 1 according to the present disclosure is made of a silicon-carbide-based ceramic, a silicon-carbide-based ceramic has a higher rigidity than other ceramics, and thus it is not readily bent, and even when the stress due to cure shrinkage of the sealing material 4 occurs in sealing the semiconductor chips 3 with the use of the sealing material 4, positional misalignment of the semiconductor chips 3 due to a bend of the support substrate 1 is not readily generated, thereby leading to improvement in the yield.

For example, an aluminum-oxide-based ceramic is a ceramic whose main component is aluminum oxide. That aluminum oxide is a main component means a case where aluminum oxide occupies equal to or more than 70% by mass of 100% by mass of all components composing the ceramic.

A material of the support substrate 1 according to the present disclosure may be identified by the following method. First, the support substrate 1 is measured by using an X-ray diffractometer (XRD: manufactured by BrukerAX, D8 ADVANCE, for example) and identification thereof is executed from a value of an obtained 2θ (where 2θ is diffraction angle) by using a JCPDS card. Then, quantitative analysis of each component is executed by using an Inductively Coupled Plasma (ICP) emission spectrophotometer (ICP) or an X-ray fluorescence spectrometer (XRF). When the presence of aluminum oxide is confirmed in the XRD and a content obtained by converting a content of aluminum (Al) measured by an ICP or an XRF into aluminum oxide (Al₂O₃) is equal to or more than 70% by mass, it is an aluminum-oxide-based ceramic. The same is applied to other ceramics.

An arithmetic mean roughness Ra of the first surface 1a of the support substrate 1 according to the present disclosure, which is obtained from a roughness curve, is equal to or less than 0.5 µm, and a skewness Rsk thereof, which is obtained from the roughness curve, is minus. When such a configuration is satisfied, a residual of air in valleys of the first surface 1a, which becomes a cause for reduction in the bonding strength, is reduced and a contact area between the first surface 1a and the bonding film 2 becomes large, so that a bonding strength of the support substrate 1 according to the present disclosure to the bonding film 2 is high.

The arithmetic mean roughness Ra means a value that is prescribed in JIS B 0601-2013. The skewness Rsk is prescribed in JIS B 0601-2013, and is an index indicating a ratio between a peak and a valley when an average height of a roughness curve is a center line.

A first ratio (Rpk / Rvk) of the first surface 1a of the support substrate 1 according to the present disclosure between a depth of protruding valley Rvk obtained from a roughness curve and a height of protruding peak Rpk obtained from the roughness curve may be equal to or less than 0.8.

When such a configuration is satisfied, an average depth of protruding valleys in the first surface 1a is deep, and thus an anchor effect caused by the bonding film 2 having penetrated into the protruding valleys works effectively so as to improve a bonding strength of the support substrate 1 according to the present disclosure to the bonding film 2.

Particularly, when a first ratio of the first surface 1a is equal to or less than 0.2, the bonding strength of the support substrate 1 according to the present disclosure to the bonding film 2 is more improved.

The depth of protruding valley Rvk and the height of protruding peak Rpk are prescribed in JIS B 0671-2-2002, and are according to the following definition. First, in a center part of a load curve that includes 40% of measurement points of a roughness curve, a linear line having the gentlest slope, among secants of the load curve that are drawn by making a difference of a load length ratio 40%, is set to an equivalent curve. Next, an interval between two height positions, at which the equivalent curve intersects with a vertical axis at load length ratios 0% and 100%, is set to a core section. In roughness curve, an average depth of protruding valleys under the core section is the depth of protruding valley Rvk, and an average height of protruding peaks on or above the core section is the height of protruding peak Rpk.

In the first surface 1a of the support substrate 1 according to the present disclosure, a second ratio (Rq / Ra) between the arithmetic mean roughness Ra obtained from a roughness curve and a root mean square roughness Rq obtained from the roughness curve may be equal to or less than 1.7. When such a configuration is satisfied, protruding valleys are few in the first surface 1a, and thus a residual of air in valleys is reduced, so that a bonding strength of the support substrate 1 according to the present disclosure to the bonding film 2 is improved.

Particularly, when a second ratio of the first surface 1a is equal to or less than 1.4, a bonding strength of the support substrate 1 according to the present disclosure to the bonding film 2 is more improved. Note that the root mean square roughness Rq indicates a value prescribed in JIS B 0601-2013.

In the first surface 1a of the support substrate 1 according to the present disclosure, a kurtosis Rku obtained from a roughness curve may be more than 3 and equal to or less than 11. When such a configuration is satisfied, in the first surface 1a, a neighborhood of a vertex of a valley has a moderately-sharp shape, and thus the bonding film 2 readily penetrates into a bottom of the valley when the bonding film 2 is pasted to the first surface 1a, and an anchor effect caused by the bonding film 2 having penetrated into valleys works more effectively. Thus, a bonding strength of the support substrate 1 according to the present disclosure to the bonding film 2 is improved.

Note that the kurtosis Rku is an index indicating a kurtosis that is a scale of sharpness of a surface, which is prescribed in JIS B 0601-2013.

In the first surface 1a of the support substrate 1 according to the present disclosure, a maximum valley depth Rv obtained from a roughness curve may be equal to or less than 4.0 µm. When such a configuration is satisfied, the bonding film 2 readily penetrates into a bottoms of the valley when the bonding film 2 is pasted to the first surface 1a, and thus a bonding strength of the support substrate 1 according to the present disclosure to the bonding film 2 is improved. Note that the maximum valley depth Rv is a value prescribed in JIS B 0601-2013, and is the maximum depth of valleys in a reference length that is obtained by extracting the reference length from a roughness curve in a direction of an average line.

In the first surface 1a of the support substrate 1 according to the present disclosure, a third ratio (S / RSm) between an average convex-concave spacing RSm, which is obtained from a roughness curve, and an average peak-vertex spacing S, which is obtained from the roughness curve, may be equal to or more than 0.4 and equal to or less than 0.7. If such a configuration is satisfied, when the bonding film 2 is pasted to the first surface 1a, an anchor effect caused by the bonding film 2 having penetrated into valleys works more effectively, and a residual of air in the valleys is reduced. Thus, a bonding strength of the support substrate 1 according to the present disclosure to the bonding film 2 is improved.

The average convex-concave spacing RSm is prescribed in JIS B 0601-2013, and is an index that indicates an average value of intervals when a total length of a center line corresponding to one peak and one valley adjacent to the one peak is defined as an interval of a peak and a valley. The average peak-vertex spacing S is prescribed in JIS B 0601-1994, and is an index that indicates an average value of intervals between adjacent peak vertices.

In the first surface 1a, the average convex-concave spacing RSm may be, for example, equal to or more than 21.2 µm and equal to or less than 28.5 µm, and the average peak-vertex spacing S may be, for example, equal to or more than 8.5 µm and equal to or less than 19.9 µm.

In the first surface 1a of the support substrate 1, the arithmetic mean roughness Ra, the skewness Rsk, the root mean square roughness Rq, the kurtosis Rku, the maximum valley depth Rv, and the average convex-concave spacing RSm are measured and obtained in compliance with JIS B 0601-2013, the depth of protruding valley Rvk and the height of protruding peak Rpk are measured and obtained in compliance with JIS B 0671-2-2002, and the average peak-vertex spacing S is measured and obtained in compliance with JIS B 0601-1994. As measurement conditions, for example, a measurement length may be set to 4 mm, a Cut-off value may be set to 0.8 mm, a stylus whose stylus-radius is 2 µm may be used, and a scanning speed may be set to 1 mm/s. Furthermore, it is sufficient that at least three or more points are measured in the first surface 1a of the support substrate 1 and an average value thereof is obtained.

Next, one example of a fabrication method of the support substrate 1 according to the present disclosure will be explained. Hereinafter, a case will be explained in which the support substrate 1 is made of an aluminum-oxide-based ceramic.

First, aluminum oxide (Al₂O₃) powder whose average particle diameter is equal to or more than 1 µm and equal to or less than 2 µm is prepared. Next, powder containing at least one of a silicon oxide (SiO₂), a calcium oxide (CaO), and a magnesium oxide (MgO) is prepared as sintering aid powder. Next, each of the aluminum oxide powder and the sintering aid powder is weighed in such a manner that the aluminum oxide powder occupies equal to or more than 70% by mass of 100% by mass of a total of the powders (aluminum oxide powder and sintering aid powder). Next, the mixed powder is charged into a tumbling mill along with a solvent such as water to be mixed. Next, equal to or more than 4% by mass and equal to or less than 8% by mass of a binder containing at least one of polyvinyl alcohol, polyethylene glycol, acrylic resin, butyral resin, etc. is added to 100% by mass of the mixed powder. Next, by using high-purity alumina balls, they are further mixed by the tumbling mill to obtain a slurry.

Next, the slurry is changed into a granulated body by using a spray dryer. The granulated body is formed by a roll compacting method or a Cold Isostatic Pressing (CIP) to obtain a plate-shaped molded body. Cutting may be performed on the molded body, if necessary. A size of the molded body after sintering may be 0.5 mm × 250 mm × 250 mm to 60 mm × 700 mm × 700 mm (thickness × length × width).

Firing is performed on the obtained molded body in an atmospheric air atmosphere at a maximum temperature of equal to or more than 1500 °C to equal to or less than 1700 °C for equal to or more than 15 minutes to equal to or less than 10 hours of a maximum-temperature holding time interval to obtain a sintered body.

Next, double-side polishing is performed on the obtained sintered body. As conditions of the double-side polishing, it is sufficient that an upper sharpening stone and a lower sharpening stone having abrasives made of diamond each having grit equal to or more than #100 and equal to or less than #2000 are used, and the pressure applied to the upper sharpening stone is equal to or more than 0.02 kgf/cm² and equal to or less than 0.3 kgf/cm², and a peripheral speed of the lower sharpening stone is equal to or more than 50 mm/s and equal to or less than 1800 mm/s. When the double-side polishing is appropriately adjusted within the above-mentioned conditions, it is possible to make the first surface 1a of the support substrate 1 have an arbitrary surface profile and further to obtain the support substrate 1 according to the present disclosure.

Hereinafter, although a practical example(s) according to the present disclosure will be explained specifically, the present disclosure is not limited to such a practical example(s).

### Practical Example 1

Samples whose arithmetic mean roughness Ra and the skewness Rsk of first surfaces were different from each other were fabricated, and their bonding strengths to a bonding film were evaluated.

First, an aluminum oxide powder whose average particle diameter was 1.6 µm was prepared. Next, as a sintering aid powder, powder was prepared whose content mass ratio of a silicon oxide, a calcium oxide, and a magnesium oxide was 6:1:3. Each of the aluminum oxide powder and the sintering aid powder was weighed in such a manner that an aluminum oxide powder occupied 96% by mass of 100% by mass of a total of the powders (aluminum oxide powder and sintering aid powder) to obtain a mixed powder. Next, the mixed powder was charged into a tumbling mill along with water to be mixed. Next, a binder made of an acrylic resin that occupied 6% by mass of 100% by mass of the mixed powder was added thereto. Next, by using high-purity alumina balls, they were further mixed by the tumbling mill to obtain a slurry.

Next, the slurry was changed into a granulated body by using a spray dryer. A plate-shaped molded body was obtained in a roll compacting method by using the above-mentioned granulated body. Cutting was performed on the molded body, and a size of the molded body was formed into a circular-disk shape whose sintered thickness × diameter was 1 mm × 300 mm.

Next, the obtained molded body was fired in an atmospheric air atmosphere at a maximum temperature of 1550 °C for 1 hour of a maximum-temperature holding time interval to obtain a sintered body.

Double-side polishing was performed on the sintered body in such a manner that a surface profile of a surface to be a first surface was a value in Table 1 to obtain each sample.

Next, for each of the obtained samples, measurement of the arithmetic mean roughness Ra and the skewness Rsk was executed on a corresponding first surface in compliance with JIS B 0601-2013 with the use of a contact-type surface roughness tester. As measurement conditions, a measurement length was set to 4 mm, a Cut-off value was set to 0.8 mm, a stylus whose stylus-radius was 2 µm is used, and a scanning speed was set to 1 mm/s. Three points were measured on the first surface and an average value thereof was obtained.

Next, a bonding strength to a bonding film of each of the samples was evaluated by the following method.

First, as a bonding film, a thermal expansion adhesive sheet was prepared, which was obtained by mixing and forming an adhesive whose main component was an acrylic polymer and a forming agent made of a thermal expansion bead expanding at 200 °C. Next, the thermal expansion adhesive sheet was pasted to a first surface of each of the samples. Next, each sample was put into a thermal shock testing device and a cycle is repeatedly executed, in which a temperature thereof was raised from a room temperature (25 °C) to 170 °C, then is held for 10 minutes, and then a temperature thereof was decreased to the room temperature. Each sample was retrieved for each 100 cycles, and whether or not the bonding film was peeled from a first surface of a corresponding support substrate was recognized. Orders was provided to the samples in the order from largest cycle number to lowest cycle number that was needed for peeling the bonding film (hereinafter, may be referred to as "needed cycle number"). Note that the first place was provided to a sample having the largest needed cycle number, and the last place was provided to a sample having the smallest needed cycle number. It was indicated that a bonding strength to a bonding film was higher as a needed cycle number was larger.

Results are illustrated in Table 1.

**Table 1**

| Sample No. | Ra (µm) | Rsk | Order |
|---|---|---|---|
| 1 | 0.44 | 0.1 | 5 |
| 2 | 0.50 | -0.1 | 4 |
| 3 | 0.33 | -0.7 | 1 |
| 4 | 0.31 | -3.0 | 2 |
| 5 | 0.28 | -3.5 | 3 |
| 6 | 0.78 | -0.5 | 6 |

As illustrated in Table 1, the orders of samples No. 2 to 5 were higher than those of samples No. 1 and 6. From these results, it was found that, when the arithmetic mean roughness Ra was equal to or less than 0.5 µm and the skewness Rsk was minus in a first surface, a bonding strength to a bonding film was high.

### Practical Example 2

Next, samples were fabricated whose depth of protruding valley Rvk and height of protruding peak Rpk in their first surfaces were different from each other, and their bonding strengths to a bonding film were evaluated.

A fabrication method for samples was similar to the fabrication method for sample No. 3 according to Practical Example 1 except that double-side polishing was performed so that surface profile of first surfaces became values illustrated in Table 2. Note that sample No. 7 is the same as sample No. 3 according to Practical Example 1.

Next, measurement of the depth of protruding valley Rvk and the height of protruding peak Rpk was performed on a first surface of each of the obtained samples. Note that measurement conditions were the same as those according to Practical Example 1 on the basis of JIS B 0671-2-2002.

A bonding strength of each sample to a bonding film was evaluated in the same method as that of Practical Example 1.

Results are illustrated in Table 2. Orders illustrated in Table 2 are provided by comparison between only the samples illustrated in Table 2.

**Table 2**

| Sample No. | Rpk (µm) | Rvk (µm) | First Ratio Rpk / Rvk | Order |
|---|---|---|---|---|
| 7 | 0.82 | 0.74 | 1.1 | 6 |
| 8 | 0.51 | 0.64 | 0.8 | 5 |
| 9 | 0.29 | 0.60 | 0.5 | 4 |
| 10 | 0.28 | 1.11 | 0.3 | 3 |
| 11 | 0.25 | 1.32 | 0.2 | 2 |
| 12 | 0.10 | 1.34 | 0.1 | 1 |

As illustrated in Table 2, the orders of samples No. 8 to 12 were higher than that of sample No. 7, and thus it was found that when, a first ratio in a first surface between the depth of protruding valley Rvk and the height of protruding peak Rpk was equal to or less than 0.8, a bonding strength to a bonding film was improved.

The orders of samples No. 11 and 12 were higher among samples No. 8 to 12, and thus it was found that when the first ratio was equal to or less than 0.2, a bonding strength to a bonding film was more improved.

### Practical Example 3

Next, samples were fabricated whose arithmetic mean roughness Ra and the root mean square roughness Rq in first surfaces were different from each other, and their bonding strengths to a bonding film were evaluated.

A fabrication method for samples was similar to the fabrication method for sample No. 9 according to Practical Example 2 except that double-side polishing was performed so that surface profile of first surfaces became values illustrated in Table 3. Note that sample No. 13 is the same as sample No. 9 according to Practical Example 2.

Next, measurement of the arithmetic mean roughness Ra and the root mean square roughness Rq was performed on a first surface of each of the obtained samples. Note that measurement conditions were the same as those according to Practical Example 1 on the basis of JIS B 0601-2013.

A bonding strength of each sample to a bonding film was evaluated in the same method as that of Practical Example 1.

Results are illustrated in Table 3. Orders illustrated in Table 3 are provided by comparison between only the samples illustrated in Table 3.

**Table 3**

| Sample No. | Rq (µm) | Ra (µm) | Second Ratio Rq / Ra | Order |
|---|---|---|---|---|
| 13 | 0.62 | 0.33 | 1.9 | 4 |
| 14 | 0.55 | 0.32 | 1.7 | 3 |
| 15 | 0.41 | 0.30 | 1.4 | 2 |
| 16 | 0.39 | 0.29 | 1.3 | 1 |

As illustrated in Table 3, the orders of samples No. 14 to 16 were higher than that of sample No. 13, and thus it was found that when, in a first surface, a second ratio between the arithmetic mean roughness Ra and the root mean square roughness Rq was equal to or less than 1.7, a bonding strength to a bonding film was improved.

The orders of samples No. 15 and 16 were higher among samples No. 14 to 16, and thus it was found that when the second ratio was equal to or less than 1.4, a bonding strength to a bonding film was more improved.

### Practical Example 4

Next, samples were fabricated whose kurtosis Rku in first surfaces were different from each other, and their bonding strengths to a bonding film were evaluated.

A fabrication method for samples was similar to the fabrication method for sample No. 16 according to Practical Example 3 except that double-side polishing was performed so that surface profile of first surfaces became values illustrated in Table 4. Note that sample No. 17 is the same as sample No. 16 according to Practical Example 3.

Next, measurement of the kurtosis Rku was performed on a first surface of each of the obtained samples. Note that measurement conditions were the same as those according to Practical Example 1 on the basis of JIS B 0601-2013.

A bonding strength of each sample to a bonding film was evaluated in the same method as that of Practical Example 1.

Results are illustrated in Table 4. Orders illustrated in Table 4 are provided by comparison between only the samples illustrated in Table 4.

**Table 4**

| Sample No. | Rku | Order |
|---|---|---|
| 17 | 2.5 | 5 |
| 18 | 3.2 | 3 |
| 19 | 5.8 | 1 |
| 20 | 11.0 | 2 |
| 21 | 12.3 | 4 |

As illustrated in Table 4, the orders of samples No. 18 to 20 were higher than those of samples No. 17 and 21, and thus it was found that when, in a first surface, a second ratio between the kurtosis Rku was larger than 3 and equal to or less than 11, a bonding strength to a bonding film was improved.

### Practical Example 5

Next, samples were fabricated whose maximum valley depth Rv in first surfaces were different from each other, and their bonding strengths to a bonding film were evaluated.

A fabrication method for samples was similar to the fabrication method for sample No. 19 according to Practical Example 4 except that double-side polishing was performed so that surface profile of first surfaces became values illustrated in Table 5. Note that sample No. 22 is the same as sample No. 19 according to Practical Example 4.

Next, measurement of the maximum valley depth Rv was performed on a first surface of each of the obtained samples. Note that measurement conditions were the same as those according to Practical Example 1 on the basis of JIS B 0601-2013.

A bonding strength of each sample to a bonding film was evaluated in the same method as that of Practical Example 1.

Results are illustrated in Table 5. Orders illustrated in Table 5 are provided by comparison between only the samples illustrated in Table 5.

**Table 5**

| Sample No. | Rv (µm) | Order |
|---|---|---|
| 22 | 4.4 | 3 |
| 23 | 4.0 | 2 |
| 24 | 2.1 | 1 |

As illustrated in Table 5, the orders of samples No. 23 and 24 were higher than that of sample No. 22, and thus it was found that when, in a first surface, the maximum valley depth Rv was equal to or less than 4.0 µm, a bonding strength to a bonding film was improved.

### Practical Example 6

Next, samples were fabricated whose average peak-vertex spacing S and the average convex-concave spacing RSm in first surfaces were different from each other, and their bonding strengths to a bonding film were evaluated.

A fabrication method for samples was similar to the fabrication method for sample No. 24 according to Practical Example 5 except that double-side polishing was performed so that surface profile of first surfaces became values illustrated in Table 6. Note that sample No. 25 is the same as sample No. 24 according to Practical Example 5.

Next, measurement of the average peak-vertex spacing S and the average convex-concave spacing RSm was performed on a first surface of each of the obtained samples. Note that measurement conditions were the same as those according to Practical Example 1, and the average peak-vertex spacing S is based on JIS B 0601-1944 and the average convex-concave spacing RSm is based on JIS B 0601-2013.

A bonding strength of each sample to a bonding film was evaluated in the same method as that of Practical Example 1.

Results are illustrated in Table 6. Orders illustrated in Table 6 are provided by comparison between only the samples illustrated in Table 6.

**Table 6**

| Sample No. | S (µm) | RSm (µm) | Third Ratio S / RSm | Order |
|---|---|---|---|---|
| 25 | 7.8 | 20.4 | 0.38 | 5 |
| 26 | 8.5 | 21.2 | 0.40 | 3 |
| 27 | 13.1 | 24.7 | 0.53 | 1 |
| 28 | 19.9 | 28.5 | 0.70 | 2 |
| 29 | 21.3 | 29.1 | 0.73 | 4 |

As illustrated in Table 6, the orders of samples No. 26 to 28 were higher than those of samples No. 25 and 29, and thus it was found that when, in a first surface, a third ratio between the average convex-concave spacing RSm and the average peak-vertex spacing S was equal to or more than 0.4 and equal to or less than 0.7, a bonding strength to a bonding film was improved.

### Reference Signs List

- 1: support substrate
- 1a: first surface
- 1b: second surface
- 2: bonding film
- 3: semiconductor chip
- 4: sealing material

## Claims

1. A support substrate, wherein
the support substrate is made of a ceramic, and is a plate-shaped body including a first surface and a second surface positioned opposite to the first surface, and
an arithmetic mean roughness Ra of the first surface obtained from a roughness curve is equal to or less than 0.5 µm, and a skewness Rsk of the first surface obtained from a roughness curve is minus.

2. The support substrate according to claim 1, wherein
a first ratio of the first surface between a depth of protruding valley Rvk obtained from a roughness curve and a height of protruding peak Rpk obtained from a roughness curve is equal to or less than 0.8.

3. The support substrate according to claim 2, wherein
the first ratio is equal to or less than 0.2.

4. The support substrate according to any one of claims 1 to 3, wherein
a second ratio of the first surface between an arithmetic mean roughness Ra obtained from a roughness curve and a root mean square roughness Rq obtained from a roughness curve is equal to or less than 1.7.

5. The support substrate according to claim 4, wherein
the second ratio is equal to or less than 1.4.

6. The support substrate according to any one of claims 1 to 5, wherein
a kurtosis Rku of the first surface obtained from a roughness curve is larger than 3 and equal to or less than 11.

7. The support substrate according to any one of claims 1 to 6, wherein
a maximum valley depth Rv of the first surface obtained from a roughness curve is equal to or less than 4.0 µm.

8. The support substrate according to any one of claims 1 to 7, wherein
a third ratio of the first surface between an average convex-concave spacing RSm obtained from a roughness curve and an average peak-vertex spacing S obtained from a roughness curve is equal to or more than 0.4 and equal to or less than 0.7.
